Europäisches Patentamt

European Patent Office

Office européen des brevets

(11) Veröffentlichungsnummer: **0 269 613 B1**

(12) **EUROPÄISCHE PATENTSCHRIFT**

(45) Veröffentlichungstag der Patentschrift: **17.06.92**

(21) Anmeldenummer: **87890272.5**

(22) Anmeldetag: **26.11.87**

(51) Int. Cl.⁵: **H01J 37/30**, G03F 7/20, H01J 37/317, H01J 37/147

(54) **Ionenprojektionslithographieeinrichtung.**

(30) Priorität: **27.11.86 AT 3173/86**

(43) Veröffentlichungstag der Anmeldung: **01.06.88 Patentblatt 88/22**

(45) Bekanntmachung des Hinweises auf die Patenterteilung: **17.06.92 Patentblatt 92/25**

(84) Benannte Vertragsstaaten: **AT BE DE FR GB IT NL SE**

(56) Entgegenhaltungen:

**JOURNAL OF VACUUM SCIENCE & TECHNOLOGY/A, Band 4, Nr. 3, Teil 1, Mai-Juni 1986, Seiten 777-783, American Vacuum Society, Woodbury, N.Y., US; J.N. RANDALL: Prospects for printing very large scale integrated circuits with masked ion beam lithography"**

(73) Patentinhaber: **IMS Ionen Mikrofabrikations Systeme Gesellschaft m.b.H. Schreygasse 3 A-1020 Wien(AT)**

Patentinhaber: **Österreichische Investitions- kredit Aktiengesellschaft Renngasse 10 A-1013 Wien(AT)**

(72) Erfinder: **Stengl, Gerhard, Dr. Umberg 41 A-9241 Wernberg Kärnten(AT)** Erfinder: **Löschner, Hans, Dr. Vegagasse 6/2 A-1190 Wien(AT)**

(74) Vertreter: **Casati, Wilhelm, Dipl.-Ing. et al Patentanwälte Casati, Wilhelm, Dipl.-Ing. Krause, Ernst, Dipl.-Ing. Itze, Peter, Dipl.-Ing. Amerlingstrasse 8 A-1061 Wien(AT)**

EP 0 269 613 B1

**Beschreibung**

Die Erfindung betrifft eine Ionenprojektionseinrichtung für die Schattenwurfbelichtung einer im Strahlengang zwischen Ionenquelle und Substrat angeordneten, körperliche Öffnungen aufweisenden Maske (open stencil mask) mittels divergentem Ionenstrahl, wobei der Raum zwischen Maske und Substrat von Abbildungseinrichtungen (Linsen) frei ist und im Strahlengang zwischen Ionenquelle und Substrat (Wafer) mindestens eine Einrichtung zur Erzeugung eines elektrostatischen Ablenkfeldes angeordnet ist.

Open-stencil-Masken weisen aufgrund ihrer Herstellungsverfahren öfters gewisse Verzerrungen, also Lageverschiebungen der Maskenöffnungen gegenüber ihren Sollpositionen auf. Wenn nun, wie das bei Herstellung von Halbleiterschaltkreisen üblich ist, in verschiedenen Projektionsschritten verschiedene Masken auf dieselbe Substratfläche abgebildet werden, so werden, weil die verschiedenen Masken im allgemeinen verschiedene Verzerrungszustände aufweisen, auf dem Substrat nicht tolerable Versetzungen der von einer Maske herrührenden Strukturen, gegenüber Strukturen, die von einer anderen Maske herrühren, auftreten. Darum ist es notwendig, die Verzerrung jeder Maske während der Abbildung so zu kompensieren, daß auf dem Substrat nur mehr tolerable Versetzungen auftreten.

Von wirtschaftlichem Vorteil ist das sogenannte "Mix-and-Match"-Verfahren. Hierbei wird die Strukturierung jeweils eines Halbleiterschaltelements in zwei oder mehreren verschiedenen Anlagen durchgeführt. Beispielsweise kann die gröbere Strukturierung mit einem, im Betrieb billigeren, optischen Wafer-Stepper und die feinere in einer Ionen-Projektionsanlage ausgeführt werden. In diesem Fall muß in der Ionen-Projektionsanlage die Abbildung der dort verwendeten Masken an den Verzerrungszustand der im optischen Wafer-Stepper erzeugten Strukturen angepaßt werden, d.h. die in der Maske gegebene Lage der Öffnungen zueinander muß in der Abbildung verändert (verzerrt) werden.

Es ist ein Verfahren bekannt (H.Bohlen et al. Solid State Technology, Sept.84, 5.210), bei dem ein enger Elektronenstrahl (Durchmesser ca. I mm) mittels eines zeitlich variierenden elektrostatischen Ablenkfeldes rasterförmig über die abzubildende Maske geführt wird ("Scanning"), wobei gewisse Verzerrungen der Maske durch entsprechende Änderung des Ablenkwinkels ausgeglichen werden. Diese Methode ist jedoch nur bei scannenden Projektionsverfahren anwendbar, da immer der ganze Strahl homogen abgelenkt wird.

Es wurde weiters bekannt, die Struktur einer "Open-stencil"-Maske durch ein Bündel paralleler Ionenstrahlen auf einem Wafer abzubilden und dabei den Raum zwischen Wafer und Maske von Abbildungseinrichtungen freizuhalten (Journal of Vacuum Science & Technology/A, Band 4, Nr. 3, Teil 1, Mai-Juni 1986, Seiten 777 - 783, American Vacuum Soeiety, Woodbury, N.Y., US; J.H.Randall: Prospects for printing very large scale integrated circuits with masked ion beam lithography) . Das Strahlenbündel aus parallelen Strahlen wird bei der bekannten Anordnung durch den Raum zwischen einem Paar von voneinander beabstandeten Ablenkplatten, die vor der Maske angeordnet sind, hindurchgeführt. Die Ablenkplatten bewirken - analog zu dem vorerwähnten scannenden Projektionsverfahren - eine homogene Ablenkung des gesamten Ionenstrahlenbündels.

Eine ebenfalls bekanntgewordene Ionenprojektionslithographieeinrichtung sieht im Strahlengang einen Oktopol vor, der zwischen einer Immersionslinse und dem eigentlichen, vor dem Wafer angeordneten Projektionslinsensystem angeordnet ist (Solid StateTechnology, Band 29, Nr. 2, Februar 86, Seiten 119 - 126, Port Washington, New-York, US., G.Stengl et al. "Ion Projection Lithography"). Die Maske befindet sich hierbei zwischen Ionenquelle und der Immersionslinse und wird von einem divergenten Ionenstrahlenbündel beleuchtet. Der Oktopol wirkt hingegen auf ein konvergentes Strahlenbündel ein, das bereits - weil es nach der Maske liegt - die gesamte Bildinformation enthält, so daß der Oktopol die Bildinformation der Maske verändert.

Die Erfindung hat nunmehr die Aufgabe, bei einer Abbildung (Schattenprojektion), deren Maßstab im wesentlichen 1:1 beträgt, Möglichkeiten der elektronischen Verzerrungskorrektur bzw. -einstellung und der Maßstabseinstellung zu schaffen.

Zur Erreichung der Verzerrungskorrektur bzw. -einstellung bei nichtscannenden Schattenprojektionsverfahren, in denen ein statischer divergenter Ionenstrahl auf das gesamte abzubildende Feld der Maske auftritt, nämlich bei einer Ionenprojektionseinrichtung für die Schattenwurfbelichtung einer im Strahlengang zwischen Ionenquelle und Substrat angeordneten, körperliche Öffnungen aufweisenden Maske (open stencil mask) mittels divergentem Ionenstrahl, wobei der Raum zwischen Maske und Substrat von Abbildungseinrichtungen (Linsen) frei ist (Schattenprojektion) und im Strahlengang zwischen Ionenquelle und Substrat mindestens eine Einrichtung zur Erzeugung eines elektrostatischen Ablenkfeldes angeordnet ist, wird erfindungsgemäß vorgeschlagen, daß die Einrichtung zur Erzeugung des elektrostatischen Ablenkfeldes als vor der Maske angeordneter Multipol mit mindestens 8 Polen ausgebildet ist und daß der Bereich zwischen Multipol und Maske frei von weiteren Ablenkungseinrichtungen für den Ionenstrahl ist. Wird dieser Mul

tipol mit mindestens acht, bevorzugt aber mehr Polen aktiviert, so wird je nach Einstellung der angelegten Spannungen eine inhomogene Ablenkung der durch die Maskenöffnungen hindurchtretenden Teilstrahlen erreicht, und der abgelenkte Teilstrahl trifft unter einem geänderten Winkel auf die Maske auf, sodaß das Schattenbild der Maskenöffnungen auf dem Wafer, der sich unterhalb der Maske befindet, verändert wird. Durch Einstellen z.B. eines Dipolfeldes am erfindungsgemäßen Multipol kann aber auch eine homogene Ablenkung aller Teilstrahlen erreicht werden.

Für den Abstand Maske - Wafer wurden bisnun Werte in der Größenordnung von weniger als 0,1 mm (R.Speidel, U.Behringer, Optik 54, S. 439,1979) durchgeführt, da nur so Submikrometerstrukturen abgebildet werden konnten. Bei höheren Abstäden ist bei gleichbleibender Qualität der Ionenquelle eine Verringerung der Auflösung gegeben, bei gleichbleibendem Abstand Ionenquelle-Maskegemäß` $A = = D.h/s$, worin A die Ausdehnung der kleinsten erzeugbaren Struktur, D den Durchmesser der Ionenquelle und s die Entfernung der Ionenquelle von der Maske und h den Abstand Maske- Wafer bedeuten. In weiterer Ausgestaltung der Erfindung ist vorgesehen, daß das Substrat in großem Abstand von der Maske angeordnet ist, wobei dieser Abstand beispielsweise in der Größenordnung von 5 bis 10 mm gelegen sein kann. Zur Aufrechterhaltung der geforderten Auflösung muß nach obiger Gleichung gleichzeitig der Durchmesser der Quelle verringert under/oder der Abstand der Maske von der Quelle vergrößert werden. Durch diese Maßnahme gelingt es, am Substrat eine relativ große Lageänderung des Bildes bei relativ geringer Ablenkung des Strahles, zu erreichen. Geringe Ablenkungen sind anzustreben, um ungünstige Einflüsse (Verzerrungen), die durch die elektrischen Randfelder des Korrekturelementes verursacht werden können, klein zu halten.

Um eine Drehung der Struktur zu erreichen, kann in Weiterbildung der Erfindung, eine Einrichtung zur Erzeugung eines axialen Magnetfeldes, z.B. eine koaxial zur optischen Achse angeordnete Spule, vorgesehen werden. Bei einer solchen Ausgestaltung können Drehungen des Bildes vorgenommen werden, sodaß die daraus resultierenden Lageänderungen eine entsprechende Deckung der durch Ionenlithographie zu erzeugenden Strukturen mit auf dem Wafer bereits vorhandenen Strukturen erzielen lassen.

Im Raum zwischen der Maske und dem Substrat, dem sogenannten Proximity gap, kann ein, insbes. mechanischer, Shutter angeordnet werden. Dies bietet die Möglichkeit, auch während Lageänderungen des Wafers, in welcher Zeit eine Belichtung des Wafers unterbleiben muß, die Maske weiter dem Ionenstrahl auszusetzen und solcherart ihre Temperatur konstant zu halten, wodurch etwaige Lageänderungen von Maskenöffnungen, wie sie bei Temperaturschwankungen sonst auftreten können, sicher innerhalb der geforderten Toleranzen gehalten werden können.

Nach einer weiteren Ausgestaltung der erfindungsgemäßen Einrichtung können im Raum zwischen der Maske und dem Substrat elektronische Detektoren angeordnet werden, die dazu dienen, die Lage des Substrates bzw. die Lage von auf dem Substrat befindlichen Strukturen zu erkennen. Aufgrund dieser Erkennung können dann mittels des Multipoles die Teilstrahlen, die durch die Maskenöffnung hindurchtreten, gesteuert werden, bis die Lage der durch Ionenprojektion erzeugten Strukturen auf dem Substrat die gewünschte Sollposition einnehmen. Auf diese Weise kann ein Alignment von auf dem Wafer bereits bestehenden mit neu zu erzeugenden Strukturen vorgenommen werden. Durch Ändern des Abstandes Maske - Wafer kann aufgrund des divergenten Strahlenganges auch eine Maßstabseinstellung durchgeführt werden.

Die Erfindung wird nachstehend anhand eines in der Zeichnung schematisiert wiedergegebenen Ausführungsbeispieles näher erläutert.

Fig. 1 zeigt dabei schematisch eine Ionenprojektionseinrichtung,

Fig. 2 als Beispiel die schematische Darstellung eines aktivierten Oktopols,

Fig. 3 schematisch die Änderung eines auf ein Substrat projizierten Bildes einer Maske, und

Fig. 4 die Lageänderung eines Ionenstrahles, wie sie mittels der in Fig. 1 dargestellten Einrichtung durchgeführt werden kann.

In der Zeichnung ist dabei mit 1 eine Ionenquelle, bevorzugt eine Duoplasmatronionenquelle, bezeichnet, von der ein divergenter Ionenstrahl 9 ausgesendet wird. Unter dieser Ionenquelle befindet sich in einem Abstand von beispielsweise 500 mm eine Maske 4 mit Maskenöffnungen 11, die in einem Halter 6 gehalten ist. Unter der Makse 4, in einem Abstand s, befindet sich ein Substrat (Wafer) 2. Das Substrat kann dabei ein Si-Wafer mit entsprechendem Schichtaufbau 7 sein. Für die lithographische Strukturübertragung mittels Ionenprojektionslithographie kann der Wafer 2 beispielsweise mit einer Dreilagen-Resist(Photolack) Schicht 8 bedeckt werden, beispielsweise 1 μm AZ-Photolack als Grundschicht, eine 30 nm aufgedampfte Germaniumschicht als Zwischenlage und ein dünner Photoresist als oberste Schichte. Nach der Schattenprojektionsbelichtung mint Ionen aus der Ionenquelle 1 wird die oberste Resistschichte entwickelt, welche dann als Maskierung für die Strukturübertragung, beispielsweise durch die bekannte reaktive Ionenätztechnik, dient. In einem speziellen Experiment wurde die oberste Schicht weggelassen und die Belichtung mit 5 keV He[+]-Ionen direkt in die Germaniumschicht durchgeführt. Nach der Belichtung konnten die bestrahlten Bereiche der Germaniumschicht in einem $CF_4$-Plasma negativ entwickelt werden. Das nach der Entwicklung verbleibende Germaniummaterial maskiert dann in einem $O_2$-Plasma den darunterliegenden Fotolack. Es war möglich, bei einem Abstand s = 5 mm zwischen Maske 4 und Substrat 2 über eine Fläche von 20 x 20 mm² kleinste Strukturen der Testmaske von 500 Linien/mm zu übertragen. Dieses Auflösungsergebnis ist darauf zurückzuführen, daß mit einer Duoplasmatronionenquelle gearbeitet wurde, deren zugeordnete virtuelle Ionenquelle sehr klein ist (Durchmesser < 50 $\mu$m) (G.Stengl et al, Journal Vac.Sci. & Technology B Vol.4, Seite 195, 1986). Aus derartigen Ionenquellen können Ströme von mehreren 100 $\mu$A mit Winkelstromdichten von > 100mA pro sr. gewonnen werden. Damit ist es möglich, bei einem Abstand von 500 mm zwischen Ionenquelle und Maske am Maskenort Ionenstromdichten in der Größenordnung von 10 $\mu$A/cm² zu erhalten. Für die Belichtung von konventionellen organischen Resistschichten (wie z.B. AZ 1350 oder PMMA) ist eine Ionendosis von ca. $10^{13}$ Ionen/cm² notwendig. Diese Dosis kann damit in Belichtungszeiten von etwa 0,1 sec. übertragen werden. Mit Ionenenergien von ca. 100 keV können Strukturen in konventionelle, etwa 1 $\mu$m dicke Resistschichten übertragen werden.

Unmittelbar oberhalb der Maske 4 bzw. von deren Halter 6 befindet sich ein elektrostatischer Multipol, z.B. ein Oktopol 3. Der Begriff "unmittelbar" stellt dabei keine Beschränkung der Entfernung des Multipols von der Maske dar. So kann beispielsweise ein Abstand von 10 cm zwischen einem Multipol und der Maske als "unmittelbar" im Sinne obiger Ausführungen gelten. Es kann sich auch noch eine Aperturblende zur Strahlbegrenzung zwischen Multipol 3 und Maske 4 befinden.

Dem Multipol 3 kann auch eine Einrichtung zur Erzeugung eines axialen Magnetfeldes zugeordnet sein. Hierfür kann etwa eine koaxial zur optischen Achse angeordnete Spule Verwendung finden. Diese kann in den Multipol 3 auch integriert sein.

Da bei der erfindungsgemäßen Einrichtung zwischen der Maske 4 und der Oberfläche des Substrats 2 ein großer freier Raum zur Verfügung steht, kann dort ein mechanischer Shutter angeordnet werden. Dadurch kann die Maske 4 auch dann mit Ionen bestrahlt werden, wenn das Substrat 2 nicht bestrahlt werden soll, sodaß die Temperatur der Maske konstant und damit auch die Lage der Maskenöffnungen erhalten bleibt. In dem Raum zwischen Maske 4 und der Oberfläche des Substrates 2 können auch elektronische Detektoren zum Erkennen der Lage des Substrates bzw. zum Erkennen der Lage des Substrates bzw. zum Erkennen der Lage von auf dem Substrat befindlichen Strukturen angeordnet werden. Dies ist von besonderer Bedeutung, wenn die Ionenprojektionslithographieeinrichtung als Ionenstepper, zusammen mit optischen Wafersteppern oder auch mit Elektronen- oder Röntgen-Steppern verwendet wird.

Sollen Wafer, die bereits in optischen oder anderen (etwa Röntgen)Steppern mit Strukturen versehen wurden, in den beschriebenen Ionenprojektionseinrichtungen weiter bearbeitet werden, so wäre es erforderlich, ein entsprechendes Alignement zwischen den bereits vorhandenen Strukturen und den in der Ionenprojektionslithographieeinrichtung zu erzeugenden Strukturen herzustellen. Mittels der erfindungsgemäß ausgebildeten Einrichtung gelingt dies in x, y -Richtung sowie Rotation und Maßstab (die z-Richtung ist als Richtung der ionenoptischen Achse definiert).

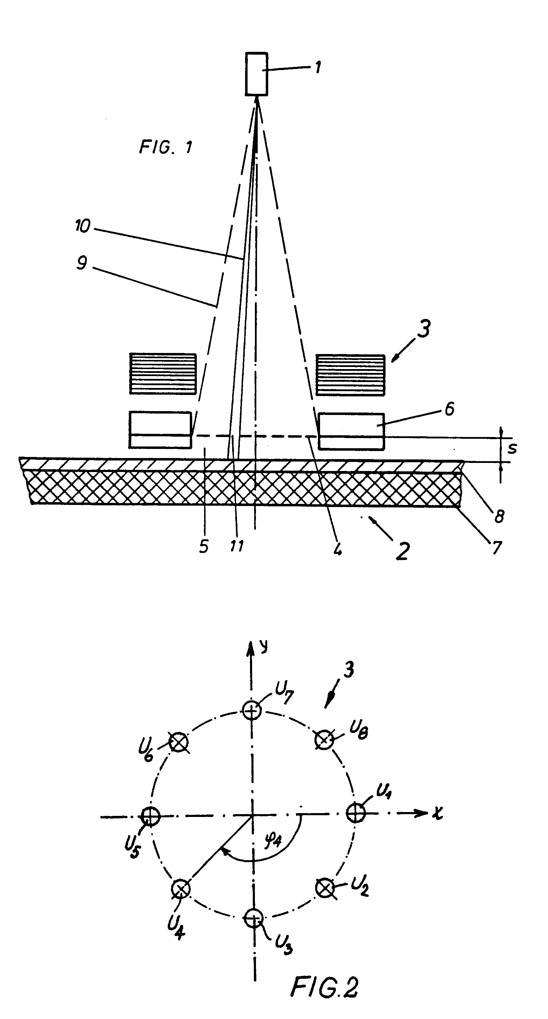

Fig. 2 zeigt schematisch einen Oktopol mit angelegten Potentialen $U_1 \ldots U_8$. Zur Erzeugung eines Dipolfeldes betragen hierbei beispielsweise: $U_1 = U_0$, $U_2 = U_0/\sqrt{2}$, $U_3 = O$, $U_4 = -U_0/\sqrt{2}$, $U_5 = -U_0$, $U_6 = -U_0/\sqrt{2}$, $U_7 = O$, $U_8 = U_0/\sqrt{2}$ ($U_i = U_0.\cos(-\phi)$), wobei $U_0$ entsprechend der Ionenenergie, der gewünschten Verschiebung in x-Richtung und dem Abstand s Maske-Wafer gewählt wird. Zur zusätzlichen Verschiebung in y-Richtung müssen den angegebenen Potentialen $U_1 \ldots U_8$ Komponenten $U_i' = U_0' . \sin \phi_i$ hinzugefügt werden.

Die erfindungsgemäße Einrichtung erlaubt auch, die Schattenprojektion der Maske mittels des Multipoles entsprechend zu entzerren bzw. auch zu verzerren. Legt man an den in Fig. 2 dargestellten Oktopol 3 beispielsweise die Potentiale:

$$U_i = U_0 . /\sin\phi_i/$$

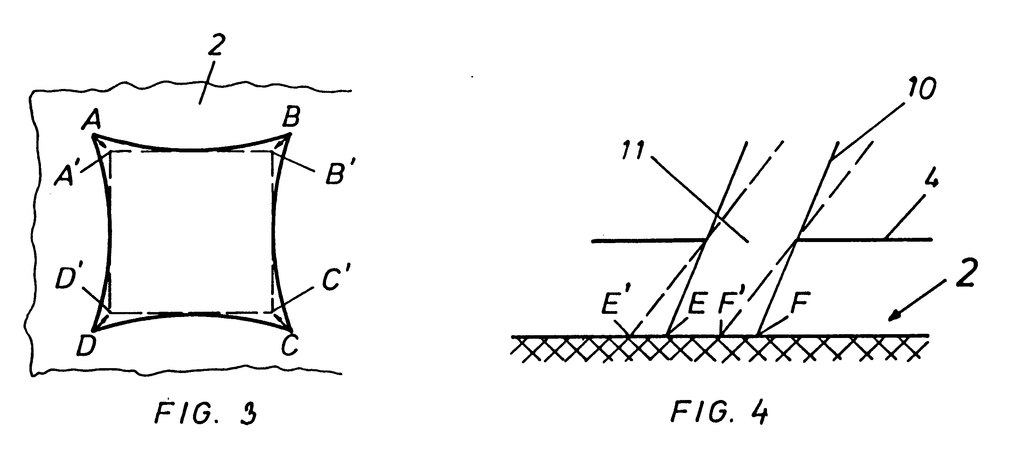

so erhält man damit in x- und in y-Richtung verschiedene Abbildungsmaßstäbe, also eine lineare Verzerrung (bzw. Entzerrung) in y-Richtung. Zur Korrektur von nicht-linearen Verzerrungen sind jedoch Multipole mit wesentlich mehr als 8 Polen (etwa 64) erforderlich, um die für die Korrektur notwendige Feldverteilung möglichst exakt einzustellen. So veranschaulicht etwa Fig. 3 die Abbildung einer quadratischen Maske, wobei die Bildpunkte mit A, B, C und D bezeichnet sind und die Quadratseiten als gekrümmte Linien erscheinen. Durch entsprechendes Aktivieren des Multipoles 3 gelingt es, die Eckpunkte A, B, C, D nach A', B', C', und D' zu schieben und auf diese Weise die Krümmung der Berandung des Quadrates zu ändern bzw. die Berandung einer geraden Linie anzunähern. Wie dabei die Verschiebung der Eckpunkte vor sich geht, veranschaulicht Fig. 4. Mit voll ausgezeichneten Linien ist hiebei ein Ionenstrahl 10 gezeichnet, der ohne Aktivierung des Multipoles 3 auf die Öffnung 11 der Maske 4 gelangt. Diese Strahlen würden dabei auf dem Substrat 2 einen Bereich E-F einnehmen. Nach Aktivieren des Multipoles 3 trifft der Strahl unter geändertem Einfallswinkel auf die Öffnung 11 der Maske 4 und erfüllt auf dem Substrat 2, den Bereich E′ - F′, der gegenüber dem Bereich E-F (in Fig. 3) nach links verschoben ist.

**Patentansprüche**

1. Ionenprojektionseinrichtung für die Schattenwurfbelichtung mittels divergentem Ionenstrahl einer im Strahlengang zwischen Ionenquelle und Substrat angeordneten Maske, die zu Abbildungszwecken dienende durchgehende körperliche öffnungen aufweist, wobei der Raum zwischen Maske und Substrat von Abbildungseinrichtungen frei ist und im Strahlengang zwischen Ionenquelle und Substrat mindestens eine Einrichtung zur Erzeugung eines elektrostatischen Ablenkfeldes angeordnet ist, dadurch gekennzeichnet, daß die Einrichtung zur Erzeugung des elektrostatischen Ablenkfeldes als vor der Maske (4) angeordneter Multipol (3) mit mindestens 8 Polen ausgebildet ist und daß der Bereich zwischen Multipol (3) und Maske (4) frei von weiteren Ablenkungseinrichtungen für den Ionenstrahl ist.

2. Einrichtung nach Anspruch 1, dadurch gekennzeichnet, daß das Substrat (2) in großem Abstand (s), z.B. in der Größenordnung von 5 mm, von der Maske (4) angeordnet ist.

3. Einrichtung nach Anspruch 1 oder 2, dadurch gekennzeichnet, daß dem Multipol (3) eine Einrichtung zur Erzeugung eines axialen Magnetfeldes zugeordnet ist.

4. Einrichtung nach einem der Ansprüche 1 bis 3, dadurch gekennzeichnet, daß im Raum (5) zwischen der Maske (4) und dem Substrat (2), i.e. im Proximity gap, ein, insbes. mechanischer, Shutter angeordnet ist.

5. Einrichtung nach einem der Ansprüche 1 bis 4, dadurch gekennzeichnet, daß im Raum (5) zwischen der Maske (4) und dem Substrat (2), i.e. im Proximity gap, elektronische Detektoren zum Erkennen der Lage des Substrates (2) bzw. von darauf befindlichen Strukturen angeordnet sind.

**Claims**

1. Device for ion projection for shadow casting illumination by means of a divergent ion beam of a mask which has bodily openings passing through it for imaging purposes and is arranged between the ion source and substrate, whereby the space between the mask and substrate is free from imaging devices and at least one device for producing an electrostatic deflecting field is arranged in the beam pathway between the ion source and substrate, characterised in that the device for producing the electrostatic deflecting field is constructed as a multipole (3) with at least 8 poles arranged in front of the mask (4) and that the region between the multipole (3) and mask (4) are free of further deflection devices for the ion beam.

2. Device as claimed in Claim 1, characterised in that the substrate (2) is arranged at a large distance (s), e.g. of the order of 5 mm, from the mask (4).

3. Device as claimed in Claim 1 or 2, characterised in that a device for producing an axial magnetic field is associated with the multipole (3).

4. Device as claimed in one of Claims 1 to 3, characterised in that a, particularly mechanical, shutter is arranged in the space (5) between the mask (4) and the substrate (2), i.e. in the proximity gap.

5. Device as claimed in one of Claims 1 to 4, characterised in that electric detectors for detecting the position of the substrate (2) or of structures situated thereon are arranged in the space (5) between the mask (4) and the substrate (2), i.e. in the proximity gap.

**Revendications**

1. Dispositif de projection d'ions pour l'éclairage avec ménagement de zones d'ombre, au moyen d'un rayonnement d'ions divergent, d'un masque présentant dans sa structure des ouvertures traversantes servant à la représentation, disposé sur la trajectoire du rayonnement entre la source d'ions et le substrat, l'espace séparant le masque du substrat étant dépourvu de dispositif de représentation, et au moins un dispositif produisant un champ de déflexion électrostatique étant disposé sur la trajectoire entre la source d'ions et le substrat, caractérisé en ce que le dispositif de production du champ de déflexion électrostatique est conformé en multipole (3) à au moins 8 pôles, disposé devant le masque (4), et en ce que la zone située entre le multipôle (3) et le masque (4) est dépourvue d'autres dispositifs de déflexion pour le rayonnement d'ions.

2. Dispositif selon la revendication 1, caractérisé en ce que le substrat (2) se situe à une distance importante (s) du masque (4), de l'ordre de 5 mm.

3. Dispositif selon la revendication 1 ou 2, caractérisé en ce qu'un dispositif produisant un champ magnétique axial est associé au multipôle (3).

4. Dispositif selon l'une quelconque des revendications 1 à 3, caractérisé en ce qu'est disposé, dans l'espace (5) séparant le masque (4) du substrat (2), c'est-à-dire dans l'espace de proximité (proximity gap), un obturateur, en particulier mécanique.

5. Dispositif selon l'une quelconque des revendications 1 à 4, caractérisé en ce que sont disposés, dans l'espace (5) séparant le masque (4) du substrat (2), c'est-à-dire dans l'espace de proximité, des détecteurs électroniques pour détecter la position du substrat (2) et/ou des structures qui se trouvent dessus.

FIG. 1

FIG.2

FIG. 3

FIG. 4

EP 0 269 613 B1